# EUROPEAN PATENT APPLICATION

(11) **EP 4 389 279 A1**
(43) Date of publication of application: **26.06.2024**
(21) Application number: 22215471.8
(22) Date of filing: 21.12.2022
(51) Int. Cl.: B01L 3/00

(54) **A MICROFLUIDIC DEVICE AND A METHOD FOR MANUFACTURING A MICROFLUIDIC DEVICE**

(71) Applicant: Imec VZW, 3001 Leuven (BE)
(72) Inventor: Zhang, Lei, 3010 Kessel-Lo (BE); Severi, Simone, 3000 Leuven (BE); Stakenborg, Tim, 3001 Heverlee (BE); Labie, Riet, 3210 Lubbeek (BE); Soussan, Philippe, 1300 Wavre (BE); Karve, Gauri, 3080 Tervuren (BE)
(74) Representative: AWA Sweden AB

(57) **Abstract**

According to an aspect of the present inventive concept there is provided a microfluidic device comprising: at least one structure arranged in a pocket-defining layer defining a pocket in the pocket-defining layer; a semiconductor chip arranged in the pocket, the semiconductor chip comprising at least one electrode at the surface of the semiconductor chip; an electrical connection layer arranged above the semiconductor chip, wherein the electrical connection layer comprises electronic connections electrically connected to the at least one electrode and arranged to extend laterally in the electrical connection layer away from the semiconductor chip; at least one fluidic channel extending through the pocket-defining layer and above the semiconductor chip, the fluidic channel being arranged to be in fluidic communication with the at least one electrode.

## Description

### Technical field

The present description relates to the field of microfluidic devices.

More particularly, the present description relates to a microfluidic device and a method for manufacturing a microfluidic device.

### Background

The field of microfluidics is rapidly evolving and the number of applications has largely increased over the past two decades. There is an increased need for new and improved research methods. Microfluidics are a good research method for both small scale and large-scale research and applications. However, combining electrical, CMOS or ASIC chips with microfluidics remains challenging, despite the value to develop such devices and combine them with further features.

Integrating electronics for measuring of features as an outcome of the research is common and increasingly used. Combining electronics and the small scale of the microfluidics has however been faced with difficulties.

Even further, a combination of microfluidics and optical components has been facing difficulties due to the need for fluidic channels in the microfluidic devices. The microfluidic channels may need large space and the optical access equally requires large free space.

Thus, there is a need for improvements in the art.

### Summary

It is an object of the present description to at least partly overcome one or more limitations of the prior art. It is an object to provide a microfluidic device suitable for electrical interconnects and imaging analysis. It is a further object to provide a method for manufacturing a microfluidic device.

This and other objects are at least partly met by the invention as defined in the independent claims. Preferred embodiments are set out in the dependent claims.

As a first aspect, there is provided a microfluidic device comprising:
at least one structure arranged in a pocket-defining layer defining a pocket in the pocket-defining layer;
a semiconductor chip arranged in the pocket, the semiconductor chip comprising at least one electrode at the surface of the semiconductor chip;
an electrical connection layer arranged above the semiconductor chip, wherein the electrical connection layer comprises electronic connections electrically connected to the at least one electrode and arranged to extend laterally in the electrical connection layer away from the semiconductor chip;
at least one fluidic channel extending through the pocket-defining layer and above the semiconductor chip, the fluidic channel being arranged to be in fluidic communication with the at least one electrode.

The microfluidic device is a microfluidic device suitable for optical access at least from a direction above the semiconductor chip. In other words, the arrangement of the microfluidic device provides optical access to a sample arranged in the microfluidic device. The microfluidic device may be suitable for use in biosensor applications.

The structure defines a pocket in a pocket-defining layer. The structure may comprise silicon or polymer. It should be understood that the pocket is defined by walls of the structure, wherein the pocket itself comprises a spacing between the walls of the structure. The pocket allows the semiconductor chip to be arranged in the pocket. The pocket may have different shapes. In other words, the pocket may have the shape of a rectangle or a circle or any other shape. It should be understood that the structure may then correspondingly have different shapes. The structure may have a height of 0.01 to 3 mm. The structure may be inert to reactions with cells or other biomaterials. The structure may comprise an oxide layer. Further, the structure may have low or minimal autofluorescence.

The semiconductor chip comprising at least one electrode at the surface of the semiconductor chip may be several different kinds of semiconductor chips. The semiconductor chip may be any kind of semiconductor chip being arranged to have at least one electrode at the surface. The semiconductor chip may be an integrated circuit chip. The semiconductor chip may be fixated into the pocket. The semiconductor chip may rest on a structure of the pocket.

The electrical connection layer is arranged above the semiconductor chip. The electrical connection layer comprises electronic connections electrically connected to the at least one electrode. The electronic connections may be a plurality of connections, such as an amount of tens or hundreds of connections. The electrical connections are arranged to extend laterally in the electrical connection layer away from the semiconductor chip. In other words, the electrical connections are arranged to extend in a plane defined by the electrical connection layer in a direction away from the semiconductor chip. It should be understood that the electrical connections may extend in one direction from the semiconductor chip or in two directions being opposite to each other. The electrical connections may further extend in three or four directions from the semiconductor chip. Thus, if the chip has a shape of a square, the electrical connections may extend from all four sides of the semiconductor chip. The electrical connections may connect the semiconductor chip to a second semiconductor chip. The electrical connections may connect the semiconductor chip to other devices arranged outside of the microfluidic device. The electrical connections may carry signals from the semiconductor chip to any device arranged to analyze the signals or carry signals from other device to the semiconductor chip to actuate the chip and stimulate sample in the fluid. Thus, during use, the semiconductor chip may read signals from a substance or sample, which may be carried by a fluid in the fluidic channel to the semiconductor chip, and by the electrical connections carry the signals to an analyzing device.

Moreover, the semiconductor chip may stimulate a sample arranged in the fluid or on the semiconductor chip by electrical, thermal or other means.

Thanks to the electronic connections extending laterally from the semiconductor chip, access for other devices or other chips for electrical communication with the semiconductor chip may be facilitated. The at least one fluidic channel is extending through the pocket-defining layer and above the semiconductor chip. The fluidic channel is arranged to be in fluidic communication with the at least one electrode. In other words, the fluidic channel is arranged to provide a fluidic connection from a side of the pocket defining layer being opposite to the arrangement of the semiconductor chip and to the semiconductor chip. It should be understood that the fluidic channel may extend through the pocket defining layer at more than one place, for instance it may extend through the pocket defining layer on two opposite sides of the semiconductor chip.

The at least one fluidic channel may be a plurality of channels, such as 2, 10, 50. 100 or 500 channels.

Thanks to the fluidic channel extending through the pocket-defining layer, the fluidic channel may provide fluidic communication to a plane below the semiconductor chip, whereas the electronic connections are arranged in a plane above the semiconductor chip. This enables microfluidic channels to be arranged in the plane below the semiconductor chip without any risk of interfering with the electronic connections in the electrical connection layer. Hence, complex arrangement of microfluidic channels may be provided.

However, it should be realized that the microfluidic device need not necessarily include microfluidic channels in the plane below the semiconductor chip.

According to an embodiment, the electronic connections of the electrical connection layer may extend along a first direction from the chip and the at least one fluidic channel may extend through the electrical connection layer at a position separated from the chip along a second direction different from the first direction.

The first direction and the second direction should be interpreted as two different directions starting from the semiconductor chip and extending along a plane of the microfluidic device. The difference between the first direction and the second direction may vary. It may be 90° between the first direction and the second direction, however it may as well be a smaller or a larger angle between the first direction and the second direction.

The at least one fluidic channel extending through the electrical connection layer may define a position in the electrical connection layer through which electronic connections cannot extend. Thanks to the electronic connections extending along a first direction different from the second direction, it may be ensured that the electronic connections do not extend through the position in which the fluidic channel extends through the electrical connection layer.

Thanks to the fluidic channel extending through the electrical connection layer at a position separated from the chip, there is a spacing along the second direction between the chip and the position in which the fluidic channel extends through the electrical connection layer.

It should therefore be realized that the electronic connections need not extend entirely along the first direction. Rather, some or all the electronic connections may extend laterally from the chip along the second direction along a distance smaller than the separation between the fluidic channel and the chip in the electrical connection layer. The electronic connections may be diverted into the first direction such that the electronic connections do not extend through the position in which the fluidic channel extends through the electrical connection layer.

Thus, the electrical connections and the fluidic channels may extend in a way not interfering with each other.

An advantage of this is that the electrical connection layer and the fluidic channel do not interfere with each other. Further, the design of the microfluidic chip may be made in various dimensions for the electrical connection layer and the pocket defining layer, since the matching of the layers are not crucial. Even further, with this arrangement, there may always be one optical plane free from electrical connections and fluidic channels making it possible to use different imaging techniques.

It should be realized that there are different ways of arrange the device. It should be understood that it would be particularly advantageous to have no overlap between the electrical connections and the fluidic channel at the point where the fluidic channel extends through the electrical connection layer. Further, it should be realized that in the same way it is particularly advantageous to not have an overlap between the electrical connections and the fluidic channel when connecting electronics to the electrical connections.

According to an embodiment, the device may further comprise a fluidic cartridge arranged below the pocket-defining layer. The at least one fluidic channel may extend from the fluidic cartridge through the pocket defining layer and above the chip.

Thus, there may be a fluidic cartridge arranged below the pocket-defining layer, such that fluidics may continue or be stored in the fluidic cartridge before and/or after being in fluidic contact with the semiconductor chip. The fluidic cartridge may provide a support structure for the semiconductor chip such that it is arranged on top of the fluidic cartridge.

The fluidic channel may extend in a second direction from the semiconductor chip and then change direction to reach the fluidic cartridge without interfering with the electrical connection layer.

According to an embodiment, the microfluidic device may further comprise a support structure arranged to fill a spacing between walls of the pocket and the semiconductor chip. The support structure may be an oxide, such as silicon oxide or any other oxide, or it may be a polymer such as benzocyclobutene (BCB) or polyimide, or any other polymer. It should be understood that the support structure may provide support to the semiconductor chip, fix the position of the semiconductor chip in the pocket, or attaching it to the structure defining the pocket.

However, it should further be understood that if no support structure is present there may be a need of a substrate below the pocket defining layer. The substrate may be the fluidic cartridge, or a separate substrate.

According to an embodiment, the at least one fluidic channel may comprise a transparent layer arranged above and spaced from the semiconductor chip.

The transparent layer may form a wall of the at least one fluidic channel. The advantage of this is that the transparent layer makes the device suitable for imaging. Thus, the transparent layer may be any type of layer suitable for imaging. It may be a glass layer of a polymer layer. The spacing between the transparent layer and the semiconductor chip may be adapted depending on the volume of fluid needed when using the device.

Further, it should be understood that a fluidic channel may be arranged as a part of any layer structure arranged above the semiconductor chip. Thus, it should be understood that the transparent layer may be arranged above the semiconductor chip with no or minimal spacing, such that the at least one fluidic channel is integrated into the transparent layer. Furthermore, the fluidic channel may comprise a fluidic layer. The fluidic layer may comprise polymer. The fluidic layer may be arranged above the semiconductor chip and below the transparent layer.

According to an embodiment, the microfluidic device may further comprise a passivation layer arranged above the electrical connection layer. The passivation layer may comprise an oxide material, such as silicon nitride, silicon oxide, hafnium oxide of the like. Following this, an opening in the passivation layer may be formed above the at least one electrode to allow the fluidic channel to be arranged in fluidic communication with the at least one electrode.

According to a second aspect, there is provided a method for manufacturing a microfluidic device, the method comprising:
a) forming a pocket by at least one structure arranged on a temporary carrier, wherein the structure is arranged in a pocket-defining layer;
b) arranging a semiconductor chip in the pocket, the semiconductor chip comprising at least one electrode at a surface of the semiconductor chip, wherein the semiconductor chip is placed with the electrode facing the temporary carrier;
c) arranging a substrate above the at least one structure and the semiconductor chip, wherein the at least one structure and the semiconductor chip is bonded to an upper plane of the substrate;
d) removing the temporary carrier such that the surface of the semiconductor chip having the electrode is exposed;
e) electrically connecting the surface of the at least one electrode to electronic connections, wherein the electronic connections are arranged in an electrical connection layer and arranged to extend laterally in the electrical connection layer away from the semiconductor chip;
f) forming at least one fluidic channel through the pocket-defining layer and above the semiconductor chip, the fluidic channel being arranged to be in fluidic communication with the at least one electrode.

Effects and features of this second aspect are largely analogous to those described above in connection with the first aspect. Embodiments mentioned in relation to the first aspect are largely compatible with the second aspect.

The method provided is a method for bottom-up manufacturing of the microfluidic device. Arranging the semiconductor chip in the pocket, which is formed by at least one structure on a temporary carrier, provides protection to the sensitive electrode by placing the electrode facing the temporary carrier.

Further, the substrate may be arranged providing a bonding to the semiconductor chip such that it is protected by the substrate and the pocket structure when the temporary carrier is removed.

According to an embodiment, the method may further comprise after b) and before c), grinding of the structure and the semiconductor chip, wherein the grinding is performed on the side facing away from the temporary carrier. This may be done to reach flat and thin pockets with an encapsulated semiconductor chip.

Further, according to an embodiment, the at least one fluidic channel may be defined by lithography, laser patterning or direct write.

Even further, according to an embodiment, the method may comprise, after e) and before f), e) i) arranging a passivation layer above the electrical connection layer. The passivation layer may comprise an oxide material, such as silicon nitride, silicon oxide, hafnium oxide of the like. After arranging the passivation layer, the fluidic connection between the fluidic channel and the semiconductor chip may need to be restored by removal of the passivation layer at the position above the semiconductor chip.

According to an embodiment, the method may further comprise removing the substrate. The substrate may be removed after d), e) or f). Thus, the pocket may comprise other supporting structures for the semiconductor chip allowing for the substrate to be removed. Thus, the semiconductor chip may while being arranged during c), be temporarily bonded to the substrate and the substrate may be removed later. The removal may be made by grinding the substrate.

According to an embodiment, the method may further comprise g) arranging a fluidic cartridge below the pocket-defining layer, such that the at least one fluidic channel is extending from the fluidic cartridge and through the pocket-defining layer.

According to an embodiment, the method may further comprise, after b) and before c), b) i) filling spacings between the chip and walls of the pocket with a support structure. The support structure may be an oxide, such as silicon oxide or any other oxide, or it may be a polymer such as BCB or polyimide, or any other polymer. It should be understood that the support structure may provide support to the semiconductor chip, fix the position of the semiconductor chip in the pocket, or attaching it to the structure defining the pocket.

According to an embodiment, during e) the electronic connections of the electrical connection layer may be arranged to extend along a first direction from the semiconductor chip and wherein during f) the at least one fluidic channel may be arranged to extend through the electrical connection layer at a position separated from the semiconductor chip along a second direction different from the first direction.

The first direction and the second direction should be interpreted as two different directions starting from the semiconductor chip and extending along a plane of the microfluidic device. The difference between the first direction and the second direction may vary. It may be 90° between the first direction and the second direction, however it may as well be a smaller or a larger angle between the first direction and the second direction.

The at least one fluidic channel extending through the electrical connection layer may define a position in the electrical connection layer through which electronic connections cannot extend. Thanks to the electronic connections extending along a first direction different from the second direction, it may be ensured that the electronic connections do not extend through the position in which the fluidic channel extends through the electrical connection layer.

Thanks to the fluidic channel extending through the electrical connection layer at a position separated from the chip, there is a spacing along the second direction between the chip and the position in which the fluidic channel extends through the electrical connection layer.

It should therefore be realized that the electronic connections need not extend entirely along the first direction. Rather, some or all the electronic connections may extend laterally from the chip along the second direction along a distance smaller than the separation between the fluidic channel and the chip in the electrical connection layer. The electronic connections may be diverted into the first direction such that the electronic connections do not extend through the position in which the fluidic channel extends through the electrical connection layer.

Thus, the electrical connections and the fluidic channels may extend in a way not interfering with each other.

An advantage of this is that the electrical connection layer and the fluidic channel do not interfere with each other. Further, the design of the microfluidic chip may be made in various dimensions for the electrical connection layer and the pocket defining layer, since the matching of the layers are not crucial. Even further, with this arrangement, there may always be one optical plane free from electrical connections and fluidic channels making it possible to use different imaging techniques.

According to an embodiment, the temporary carrier may comprise one or more alignment mark to align a position of the pocket with the one or more alignment mark. An advantage of this is that the alignment of the semiconductor chip with the structure may be easier than without the alignment, adapting it for large scale production.

According to an embodiment, the method may be configured to manufacture a plurality of microfluidic devices in parallel.

This may allow for a cheap manufacturing method of a large number of microfluidic devices. Each device being suitable for optical access of a sample at the same time as the sample is analyzed by a semiconductor chip.

According to an embodiment, the a) forming a pocket by at least one structure arranged on a temporary carrier may when a plurality of microfluidic devices is manufactured in parallel be made by a mask.

According to an embodiment, f) forming of the at least one fluidic channel may comprise arranging a transparent layer above and spaced from the semiconductor chip, wherein in case the method is configured to manufacture a plurality of microfluidic devices in parallel the transparent layer may be configured to be arranged above the plurality of microfluidic devices.

In other words, a plurality of microfluidic devices may share the same transparent layer.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 is a side view of a microfluidic device according to an embodiment.
Fig. 2 is a side view of a microfluidic device according to an embodiment.
Fig. 3 is a cross sectional top view of the microfluidic device according to an embodiment.
Fig. 4 a-f is a a schematic overview of a method according to an embodiment.
Fig. 5 is a a schematic overview of a method according to an embodiment.

### Detailed description

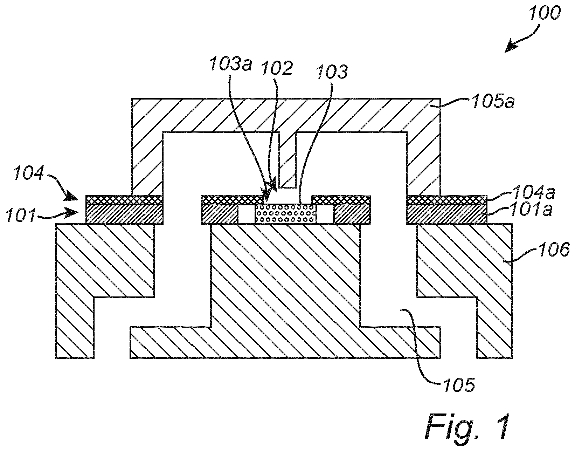

Fig. 1 illustrates a side view of a microfluidic device 100. The microfluidic device 100 comprises a silicon structure 101a arranged in a pocket-defining layer 101. It should be understood that the structure may be any other suitable structure, such as a polymer structure. The silicon structure 101a may be a silicon dioxide. The silicon structure 101a defines a pocket 102 in the pocket-defining layer 101. As can be seen in fig. 1, the pocket 102 is defined by the walls of the silicon structure 101a and the pocket 102 is defined by the spacing between the silicon structure 101a. The pocket 102 may have different shapes. In other words, the pocket 102 may have the shape of a rectangle or a circle or any other shapes. It should be understood that the silicon structure 101a may then correspondingly have different shapes. The silicon structure 101a may have a height of 0.01 - 3 mm.

A semiconductor chip 103 is arranged in the pocket 102. The semiconductor chip 103 comprises at least one electrode 103a at the surface of the semiconductor chip 103. The semiconductor chip 103 may be any kind of semiconductor chip 103 being arranged to have at least one electrode 103a at the surface. The semiconductor chip 103 may for instance comprise an integrated circuit.

The semiconductor chip 103 may be fixated into the pocket 102. The semiconductor chip 103 may rest on a structure of the pocket 102.

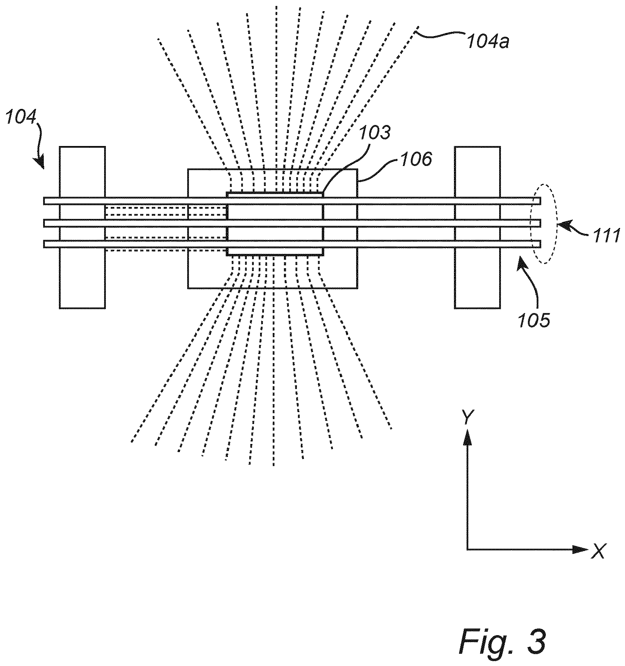

Further, the microfluidic device 100 comprises an electrical connection layer 104. The electrical connection layer 104 is arranged above the semiconductor chip 103. In other words, the electrical connection layer 104 is arranged above the pocket defining layer 103. In other words, the electrical connection layer 104 and the pocket defining layer 103 are arranged to be stacked. The electrical connection layer 104 comprises electronic connections 104a connected to the at least one electrode 103a. The electronic connections 104a are not visible in fig. 1 but will be discussed more thoroughly in relation to fig. 3. The electronic connections 104a may be a plurality of connections. The electronic connections 104a are arranged to extend laterally in the electrical connection layer 104 away from the semiconductor chip 103. As can be seen in fig. 1, the electrical connection layer 104 extends into two opposite directions from the semiconductor chip 103. However, it should be understood that it may extend in only one direction.

The electronic connections 104a may connect the semiconductor chip to a second semiconductor chip 103. The electronic connections 104a may connect the semiconductor chip 103 to other devices arranged outside of the microfluidic device 100. The electronic connections 104a may carry signals from the semiconductor chip 103 to any device arranged to analyze the signals. Thus, during use, the semiconductor chip 103 may read signals from a sample and by the electronic connections 104a carry the signals to an analyzing device.

The microfluidic device 100 further comprises at least one fluidic channel 105. The at least one fluidic channel 105 extends through the pocket defining layer 103 and above the semiconductor chip 103. The fluidic channel 105 is in fluidic communication with the at least one electrode 103a. Thus, an opening may be provided in the electrical connection layer 104 in order to provide fluidic communication between the fluidic channel 105 and the at least one electrode 103a. The relation between the at least one fluidic channel 105 and the electronic connections 104a are further explained in connection with fig. 3.

The at least one electrode 103a may be used for measuring of a substance or a sample. In other words, the fluid connection between the fluidic channel 105 and the at least one electrode 103a may be used for transporting a fluidic comprising a substance or a sample within the fluid to the at least one electrode 103a for measuring of the substance or the sample.

In fig. 1, the microfluidic device 100 further comprises a fluidic cartridge 106. The fluidic cartridge 106 is arranged below the pocket-defining layer 101. However, it should be understood that the microfluidic device 100 may not always have a fluidic cartridge 106. When the device has a fluidic cartridge 106, the at least one fluidic channel 105 may extend from the fluidic cartridge 106 through the pocket defining layer 101 and above the semiconductor chip 103. The fluidic cartridge 106 may provide a support structure for the semiconductor chip 103. In other words, the semiconductor chip 103 may be resting on the fluidic cartridge 106.

The fluidic channel 105 further comprises a transparent layer 105a. The transparent layer 105a is arranged above and spaced from the semiconductor chip 103. The transparent layer 105a may comprise glass or polymer. The spacing between the transparent layer 105a and the semiconductor chip 103a may vary depending on the use of the microfluidic device 100. The transparent layer 105a provides an optical access from above the microfluidic device 100, such that a sample arranged in the pocket 102 may be visually studied.

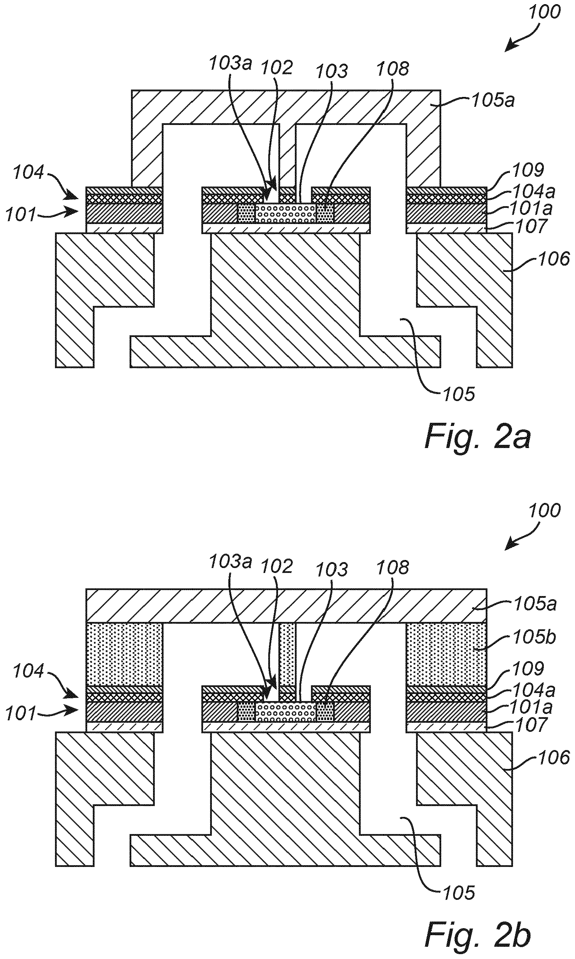

Fig. 2a and 2b illustrates each a side view of a microfluidic device 100 according to two other embodiments. For reasons of simplicity, similarities between Fig. 1 and Fig. 2a and 2b are not described below.

The microfluidic device 100 comprises a substrate 107 arranged between the fluidic cartridge 106 and the pocket defining layer 101. Thus, according to this embodiment, the semiconductor chip 103 is resting on the substrate 107. Further, the fluidic channel 105 extends through the substrate 107. The substrate 107 may be present in the microfluidic device 100 even without the fluidic cartridge 106.

Further, the microfluidic device comprises a support structure 108. The support structure 108 is arranged to fill a spacing between the walls of the pocket 102 and the semiconductor chip 103. The support structure 108 may be an oxide, such as silicon oxide or any other oxide, or it may be a polymer such as BCB or polyimide, or any other polymer. The support structure 108 may provide support to the semiconductor chip 103, attaching it to the silicon structure 101a defining the pocket 102. The support structure 108 may as in fig. 2 be arranged together with a substrate 107, however it should be understood that the support structure 108 may as well be used to support the semiconductor chip 103 without a substrate 107.

Even further, the microfluidic device 100 comprises a passivation layer 109. The passivation layer 109 may be arranged above the electrical connection layer 104. The passivation layer 109 may shield the electrical connection layer 104 from the fluidic channel 105. The fluidic channel 105 extends through the passivation layer 109 in a position aligned with a position where the fluidic channel 105 extends also through the pocket defining layer 101 for providing fluidic communication through the pocket defining layer 101. Further, an opening may be provided in the passivation layer 109 in order to provide fluidic communication between the fluidic channel 105 and the at least one electrode 103a.

As can be seen in Fig 2a the fluidic channel 105 may comprise the transparent layer 105a. In Fig 2b, it can be seen that the fluidic channel 105 may comprise the transparent layer 105a in connection with a fluidic layer 105b. The fluidic layer 105b may comprise a polymer. Further, the fluidic layer 105b may comprise the passivation layer 109.

Fig. 3 illustrates a cross sectional top view of the microfluidic device 100. For reasons of simplicity, similarities between fig. 1, fig. 2 and fig. 3 are not described below.

Fig. 3 illustrates how the electronic connections 104a of the electrical connection layer 104 extends along a first direction Y from and away from the semiconductor chip 103. The at least one fluidic channel 105 extends above the semiconductor chip 103 and are in fluid connection with the semiconductor chip. The at least one fluidic channel 105 further extend through the electrical connection layer 104 at a position 111 separated from the semiconductor chip 103 along a second direction X different from the first direction Y. The at least one fluidic channel 105 further extends into the image plane at the position 111.

As can be seen, the first direction Y and the second direction X are separated from each other such that the electronic connections 104a and the at least one fluidic channel 105 are not interfering with each other. In fig. 3 it is illustrated as there is an angle of 90° between the first direction Y and the second direction X. However, it should be understood that the angle between the first direction Y and the second direction X may be any other angle. Even further, it should be understood that the extension of the electronic connections 104a could extend partly along the second direction X, along a distance smaller than the distance between the semiconductor chip 103 and the position 111 before diverting into the first direction. Further, it should be realized that the extension of the electronic connections 104a could extend partly along the second direction X, along a distance larger than the distance between the semiconductor chip 103 and the position 111 before diverting into the first direction. Also, the at least one fluidic channel could extend along any path before reaching the position 111 at which the fluidic channel extends through the electrical connection layer 104.

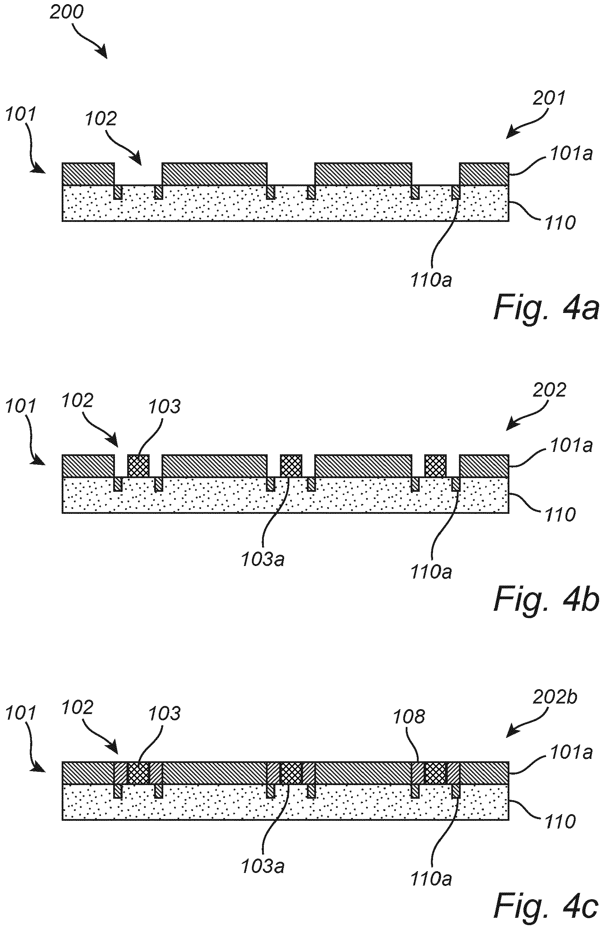

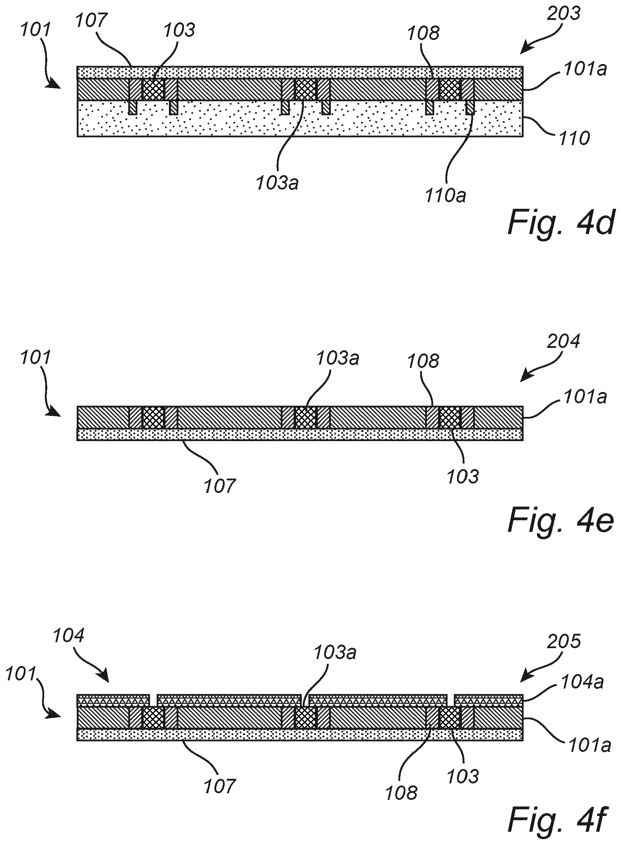

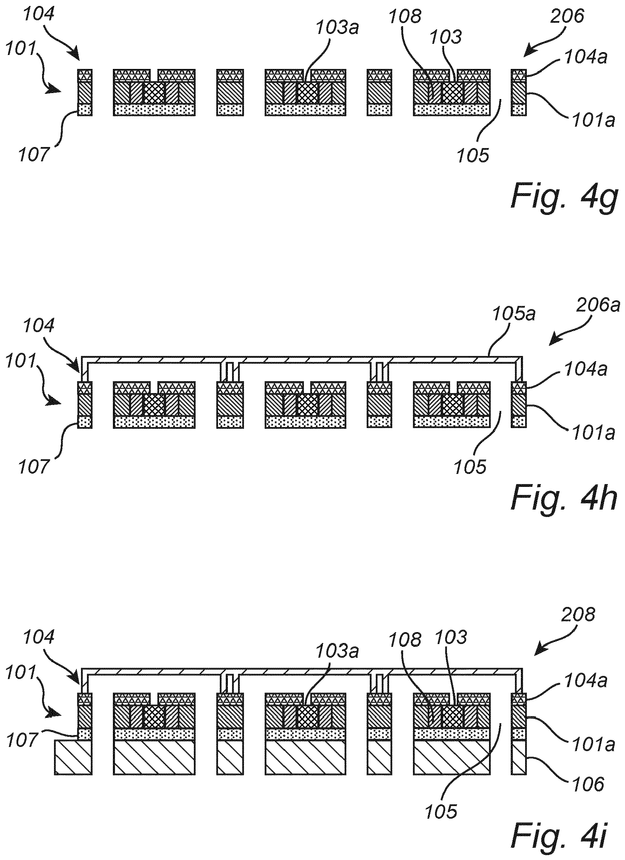

Fig. 4 a-i discloses a schematic overview of a method 200 for manufacturing a microfluidic device 100, according to an embodiment.

In fig. 4a-i, the method 200 illustrated is configured to manufacture a plurality of microfluidic devices 100 in parallel. However, it should be understood that the method 200 may be used to manufacture a single or a plurality of microfluidic devices 100.

The method 200 comprises (fig. 4a) forming 201 a pocket 102 by at least one silicon structure 101a arranged on a temporary carrier 110, wherein the silicon structure 101a is arranged in a pocket-defining layer 101. Again, it should be understood that the structure may be formed by any other suitable material, such as a polymer. The pocket 102 may be formed 201 by a reticle mask. The temporary carrier 110 may comprise one or more alignment mark 110a to align a position of the pocket 102 with the one or more alignment mark 110a.

The method further comprises (fig. 4b) arranging 202 a semiconductor chip 103 in the pocket 102. As has already been discussed, the semiconductor chip 103 comprises at least one electrode 103a at a surface of the semiconductor chip 103. The semiconductor chip 103 is during 202 placed with the electrode 103a facing the temporary carrier 110.

Not illustrated in fig 4, is an optional step of grinding 202a of the silicon structure 101a and the semiconductor chip 103. The grinding 202a is performed on the side facing away from the temporary carrier 110. This may be done to reach flat and thin pockets 102 with an encapsulated semiconductor chip 103.

Optionally, as illustrated in fig 4c, the method 200 may comprise filling 202b spacings between the semiconductor chip 103 and the walls of the pocket 102 with a support structure108. The support structure 108 may be an oxide, such as silicon oxide or any other oxide, or it may be a polymer such as BCB or polyimide, or any other polymer. It should be understood that the support structure 108 may provide support to the semiconductor chip 103, attaching it to the silicon structure 101a defining the pocket 102.

Further (fig. 4d), a substrate 107 is arranged 203 above the at least one silicon structure 101a and the semiconductor chip 103. The at least one silicon structure 101a and the semiconductor chip 103 is bonded to an upper plane of the substrate 107.

Next (fig. 4e), the temporary carrier 110 is removed 204 such that the surface of the semiconductor chip 103 having the electrode 103a is exposed.

Fig. 4f, illustrates electrically connecting 205 the surface of the at least one electrode 103 to electronic connections 104a. The electronic connections 104a are arranged in an electrical connection layer 104 and arranged to extend laterally in the electrical connection layer 104 away from the semiconductor chip 103. Further, the electronic connections 104a of the electrical connection layer 104 may be arranged to extend along a first direction Y from the semiconductor chip 103.

Next (fig. 4g), an at least one fluidic channel 105 is formed 206 through the pocket-defining layer 101 and above the semiconductor chip 103. The fluidic channel 105 being arranged to be in fluidic communication with the at least one electrode 103a. The at least one fluidic channel 105 may be defined by lithography, laser patterning, direct write, grinding or wet etching. The at least one fluidic channel 105 may be arranged to extend through the electrical connection layer 104 at a position separated from the semiconductor chip 103 along a second direction X different from the first direction Y.

The forming 206 of the at least one fluidic channel 105 may comprise arranging 206a a transparent layer 105a above and spaced from the semiconductor chip 103, as seen in fig. 4h. When the method 200 is configured to manufacture a plurality of microfluidic devices 100 in parallel the transparent layer 105a may be configured to be arranged 206a above the plurality of microfluidic devices 100.

Following this, as is illustrated in fig. 4i, the method 200 may optionally comprise arranging 208 a fluidic cartridge 106 below the pocket-defining layer 101, such that the at least one fluidic channel 105 is extending from the fluidic cartridge 106 and through the pocket-defining layer 101.

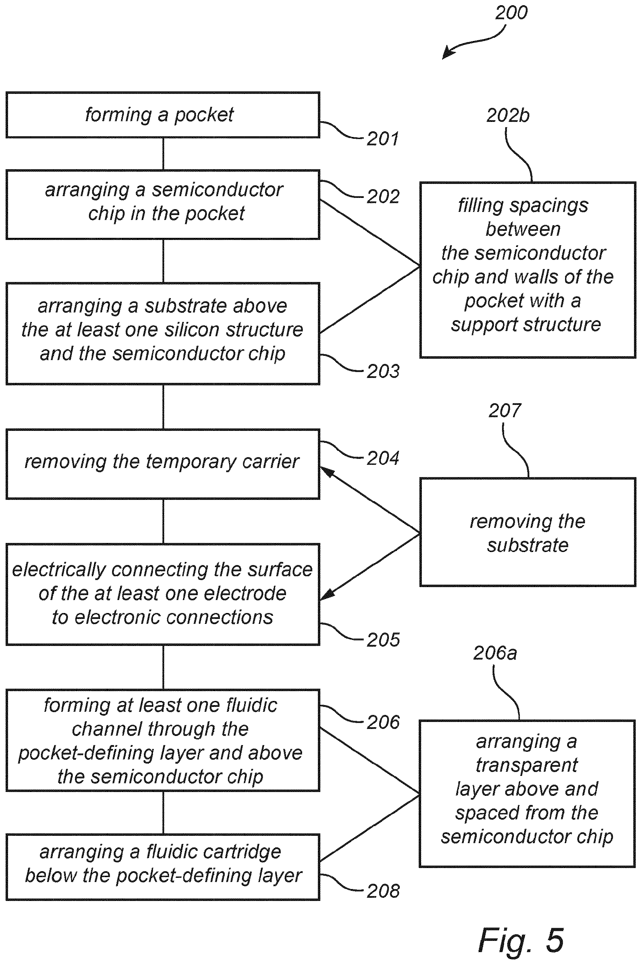

Fig. 5 discloses a schematic overview of a method 200 for manufacturing a microfluidic device, according to an embodiment. For reasons of simplicity, similarities between fig. 4 and 5 are not described below.

The method 200 may further comprise grinding 202a of the silicone structure 101a and the semiconductor chip 103. The grinding 202a is performed on the side facing away from the temporary carrier 110. This may be done to reach flat and thin pockets 102 with an encapsulated semiconductor chip 103.

The method 200 may further comprise arranging 205a a passivation layer 109 above the electrical connection layer 104. The passivation layer 109 may comprise an oxide material, such as silicon nitride, silicon oxide, hafnium oxide of the like.

Further, the method 200 may comprise removing 207 the substrate 107.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A microfluidic device (100) comprising:
at least one structure (101a) arranged in a pocket-defining layer (101) defining a pocket (102) in the pocket-defining layer (101a);
a semiconductor chip (103) arranged in the pocket (102), the semiconductor chip (103) comprising at least one electrode (103a) at the surface of the semiconductor chip (103);
an electrical connection layer (104) arranged above the semiconductor chip (103), wherein the electrical connection layer (104) comprises electronic connections (104a) electrically connected to the at least one electrode (103a) and arranged to extend laterally in the electrical connection layer (104) away from the semiconductor chip (103);
at least one fluidic channel (105) extending through the pocket-defining layer (101) and above the semiconductor chip (103), the fluidic channel (105) being arranged to be in fluidic communication with the at least one electrode (103a).

2. The microfluidic device (100) according to claim 1, wherein the electronic connections (104a) of the electrical connection layer (104) extend along a first direction (Y) from the semiconductor chip (103) and the at least one fluidic channel (105) extends through the electrical connection layer (104) at a position separated from the semiconductor chip (103) along a second direction (X) different from the first direction (Y).

3. The microfluidic device (100) according to any one of claims 1 or 2, wherein the device (100) further comprises a fluidic cartridge (106) arranged below the pocket-defining layer (101), wherein the at least one fluidic channel (105) extends from the fluidic cartridge (106) through the pocket defining layer (101) and above the semiconductor chip (103).

4. The microfluidic device (100) according to any one of claims 1 to 3, wherein the microfluidic device (100) further comprises a support structure (108) arranged to fill a spacing between walls of the pocket (102) and the semiconductor chip (103).

5. The microfluidic device (100) according to any one of claims 1 to 4, wherein the at least one fluidic channel (105) comprises a transparent layer (105a) arranged above and spaced from the semiconductor chip (103).

6. The microfluidic device (100) according to any one of claims 1 to 5, wherein the microfluidic device (100) further comprises a passivation layer (109) arranged above the electrical connection layer (104).

7. A method (200) for manufacturing a microfluidic device (100), the method (200) comprising:
a) forming (201) a pocket (102) by at least one structure (101a) arranged on a temporary carrier (110), wherein the structure (101a) is arranged in a pocket-defining layer (101);
b) arranging (202) a semiconductor chip (103) in the pocket, the semiconductor chip (103) comprising at least one electrode (103a) at a surface of the semiconductor chip (103), wherein the semiconductor chip (103) is placed with the electrode (103a) facing the temporary carrier (110);
c) arranging (203) a substrate (107) above the at least one structure (101a) and the semiconductor chip (103), wherein the at least one structure (101a) and the semiconductor chip (103) is bonded to an upper plane of the substrate (107);
d) removing (204) the temporary carrier (110) such that the surface of the semiconductor chip (103) having the electrode (103a) is exposed;
e) electrically connecting (205) the surface of the at least one electrode (103a) to electronic connections (104a), wherein the electronic connections (104a) are arranged in an electrical connection layer (104) and arranged to extend laterally in the electrical connection layer (104) away from the semiconductor chip (103);
f) forming (206) at least one fluidic channel (105) through the pocket-defining layer (101) and above the semiconductor chip (103), the fluidic channel (105) being arranged to be in fluidic communication with the at least one electrode (103a).

8. The method (200) according to claim 7, wherein the method further comprises removing (207) the substrate (109).

9. The method (200) according to any one of claim 7 or 8, wherein the method (200) further comprises g) arranging (208) a fluidic cartridge (106) below the pocket-defining layer (101), such that the at least one fluidic channel (105) is extending from the fluidic cartridge (106) and through the pocket-defining layer (101).

10. The method (200) according to any one of claim 7 to 9, wherein the method (200) further comprises, after b) and before c), b) i) filling (202b) spacings between the semiconductor chip (103) and walls of the pocket (102) with a support structure (108).

11. The method (200) according to any one of claim 7 to 10, wherein during e) the electronic connections (205) of the electrical connection layer (104) are arranged to extend along a first direction (Y) from the semiconductor chip (103) and wherein during f) (206) the at least one fluidic channel (105) is arranged to extend through the electrical connection layer (104) at a position separated from the semiconductor chip (103) along a second direction (X) different from the first direction (Y).

12. The method according to any one of claims 7 to 11, wherein the temporary carrier (110) comprises one or more alignment mark (110a) to align a position of the pocket (102) with the one or more alignment mark (110a).

13. The method (200) according to any one of claims 7 to 12, wherein the method (200) is configured to manufacture a plurality of microfluidic devices (100) in parallel.

14. The method (200) according to claim 13, wherein the a) forming (201) a pocket (102) by at least one structure (101a) arranged on a temporary carrier (110) is made by a mask.

15. The method (200) according to any one of claims 7 to 14, wherein f) forming (206) of the at least one fluidic channel (105) comprises arranging (206a) a transparent layer (105a) above and spaced from the semiconductor chip (103), wherein in case the method (200) is configured to manufacture a plurality of microfluidic devices (100) in parallel the transparent layer (105a) is configured to be arranged above the plurality of microfluidic devices (100).
